(19) Europäisches Patentamt
European Patent Office
Office européen des brevets

(11) **EP 4 316 894 A1**

(12) **EUROPEAN PATENT APPLICATION**
published in accordance with Art. 153(4) EPC

(43) Date of publication:
**07.02.2024 Bulletin 2024/06**

(21) Application number: **22779572.1**

(22) Date of filing: **10.02.2022**

(51) International Patent Classification (IPC):
*B60L 3/00* (2019.01)      *H02J 7/00* (2006.01)
*B60L 58/12* (2019.01)      *G01R 31/382* (2019.01)
*G01R 31/3828* (2019.01)      *G01R 31/3835* (2019.01)
*G01R 31/385* (2019.01)      *G01R 31/387* (2019.01)
*H01M 10/48* (2006.01)

(52) Cooperative Patent Classification (CPC):
**B60L 3/00; B60L 58/12; G01R 31/382;
G01R 31/3828; G01R 31/3835; G01R 31/385;
G01R 31/387; H01M 10/48; H02J 7/00**

(86) International application number:
**PCT/JP2022/005380**

(87) International publication number:
**WO 2022/209343 (06.10.2022 Gazette 2022/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **29.03.2021 JP 2021055410**

(71) Applicant: **Panasonic Intellectual Property
Management Co., Ltd.
Kadoma-shi, Osaka 571-0057 (JP)**

(72) Inventor: **MATSUDA Shigeru
Kadoma-shi, Osaka 571-0057 (JP)**

(74) Representative: **Novagraaf International SA
Chemin de l'Echo 3
1213 Onex, Geneva (CH)**

(54) **REMAINING CAPACITY NOTIFICATION DEVICE, REMAINING CAPACITY NOTIFICATION METHOD, AND REMAINING CAPACITY NOTIFICATION PROGRAM**

(57) In a remaining capacity notification device for notifying a user of a device of a remaining capacity of a secondary battery mounted in the device, a reliability level determination unit determines a reliability level of a state of charge (SOC) indicating the remaining capacity of the secondary battery that the user is to be notified of, on the basis of the slope of a SOC-open circuit voltage (OCV) curve of the secondary battery that corresponds to the SOC. A notification control unit performs control to cause the user to be notified of the remaining capacity of the secondary battery in a form of notification based on the reliability level of the SOC that has been determined.

FIG. 1

**Description**

Technical Field

The present disclosure relates to remaining capacity notification devices, remaining capacity notification methods, and remaining capacity notification programs for notifying users of the remaining capacity of secondary batteries.

Background Art

In recent years, electric vehicles (EVs), plug-in hybrid vehicles (PHVs), and hybrid vehicles (HVs) have become widespread. Secondary batteries are mounted in these electric motor vehicles as a key device. In the electric motor vehicles, it is important to manage the state of charge of the secondary batteries. For estimation of the SOC of secondary batteries, the current integration method and the open circuit voltage (OCV) method are mainly used. The current integration method is an estimation method mainly used during travel or during charging, and the OCV method is an estimation method mainly used while the vehicle is not in motion. In the OCV method, the SOC is estimated on the basis of the SOC-OCV curve.

When the SOC-OCV curve includes a flat region such as the SOC-OCV curve of lithium ferro phosphate (LFP) batteries, it is difficult to accurately estimate the SOC from the OCV in the flat region. Therefore, an approach has been proposed in which whether the state of a battery is in the flat region of the SOC-OCV curve is determined and when the state of the battery is in the flat region, the SOC estimated by the OCV method is not used (for example, refer to Patent Literature (PTL) 1 and 2).

Citation List

Patent Literature

PTL 1: Unexamined Japanese Patent Publication No. 2015-038437
PTL 2: Unexamined Japanese Patent Publication No. 2017-083474

Summary of Invention

With the above-described approach, if charging and discharging are frequently repeated in the flat region, OCV-based SOC error reset and full charge capacity (FCC) update are skipped. As a result, the accuracy of SOC estimation may be reduced, and unexpected deep discharge may occur. There is also an electric motor vehicle that requests a user to enable an operation for the purpose of error reset that does not align with user's intention (for example, the operation to discharge the vehicle to a low SOC, keep the vehicle stationary for a long time, and then charge the vehicle to the fully charged state).

The present disclosure is conceived in view of this situation and has an object to provide a technique for allowing users to naturally learn how to find and reset a SOC error in normal operation.

In order to solve the above problem, a remaining capacity notification device according to one aspect of the present invention is a remaining capacity notification device for notifying a user of a device of a remaining capacity of a secondary battery mounted in the device and includes: a reliability level determination unit that determines a reliability level of a SOC on the basis of a slope of a SOC-OCV curve of the secondary battery, the SOC representing a state of charge and indicating the remaining capacity of the secondary battery that the user is to be notified of, the slope corresponding to the SOC, the OCV representing an open circuit voltage; and a notification control unit that performs control to cause the user to be notified of the remaining capacity of the secondary battery in a form of notification based on the reliability level of the SOC that has been determined.

Note that an arbitrary combination of the structural elements described above and those obtained by converting the expressions described in the present disclosure into devices, methods, systems, and computer programs, for example, are also effective as embodiments of the present disclosure.

The present disclosure allows users to naturally learn how to find and reset a SOC error in normal operation.

Brief Description of Drawings

[Fig. 1] Fig. 1 is a diagram for describing an outline of an operation management support system according to an exemplary embodiment.

[Fig. 2] Fig. 2 is a diagram illustrating a schematic configuration of an electric motor vehicle according to an exemplary embodiment.

[Fig. 3] Fig. 3 is a diagram for describing a detailed configuration of a power system mounted in an electric motor vehicle according to an exemplary embodiment.

[Fig. 4] Fig. 4 is a diagram for describing the configuration of a vehicle control unit.

[Fig. 5] Fig. 5 is a diagram illustrating one example of a SOC-OCV curve and a remaining battery capacity reliability level curve.

[Fig. 6A] Fig. 6A is a diagram illustrating one example of a reliability level conversion map which is used to calculate a comprehensive SOC reliability level based on a remaining battery capacity reliability level and downtime.

[Fig. 6B] Fig. 6B is a diagram illustrating one example of a reliability level conversion map which is used to calculate a comprehensive SOC reliability level based on a remaining battery capacity reliability level and downtime.

[Fig. 7A] Fig. 7A is a diagram illustrating a display example of a remaining battery capacity displayed on a display unit of an electric motor vehicle.

[Fig. 7B] Fig. 7B is a diagram illustrating a display example of a remaining battery capacity displayed on a display unit of an electric motor vehicle.

[Fig. 7C] Fig. 7C is a diagram illustrating a display example of a remaining battery capacity displayed on a display unit of an electric motor vehicle.

[Fig. 8] Fig. 8 is a diagram illustrating the association between the length of downtime and the color of a remaining battery capacity indication when the remaining battery capacity indication reflects only the length of downtime.

[Fig. 9] Fig. 9 is a diagram for describing an operation management support system according to an exemplary embodiment.

[Fig. 10] Fig. 10 is a diagram illustrating a specific example of SOCv, a lower limit SOC, and a SOC error based on the OCV method.

[Fig. 11] Fig. 11 is a diagram illustrating a format example of battery management information.

[Fig. 12] Fig. 12 is a diagram for describing one example of a basic algorithm for operation management.

[Fig. 13A] Fig. 13A is a diagram illustrating a display example of a remaining battery capacity displayed on an operation management terminal device.

[Fig. 13B] Fig. 13B is a diagram illustrating a display example of a remaining battery capacity displayed on an operation management terminal device.

[Fig. 13C] Fig. 13C is a diagram illustrating a display example of a remaining battery capacity displayed on an operation management terminal device.

[Fig. 14] Fig. 14 is a flowchart illustrating the flow of discharging recommendation/charging recommendation determination processes for a battery pack mounted in an electric motor vehicle that is performed by an operation management support system according to an exemplary embodiment.

[Fig. 15A] Fig. 15A is a diagram illustrating another display example of a remaining battery capacity displayed on a display unit of an electric motor vehicle.

[Fig. 15B] Fig. 15B is a diagram illustrating another display example of a remaining battery capacity displayed on a display unit of an electric motor vehicle.

Description of Embodiments

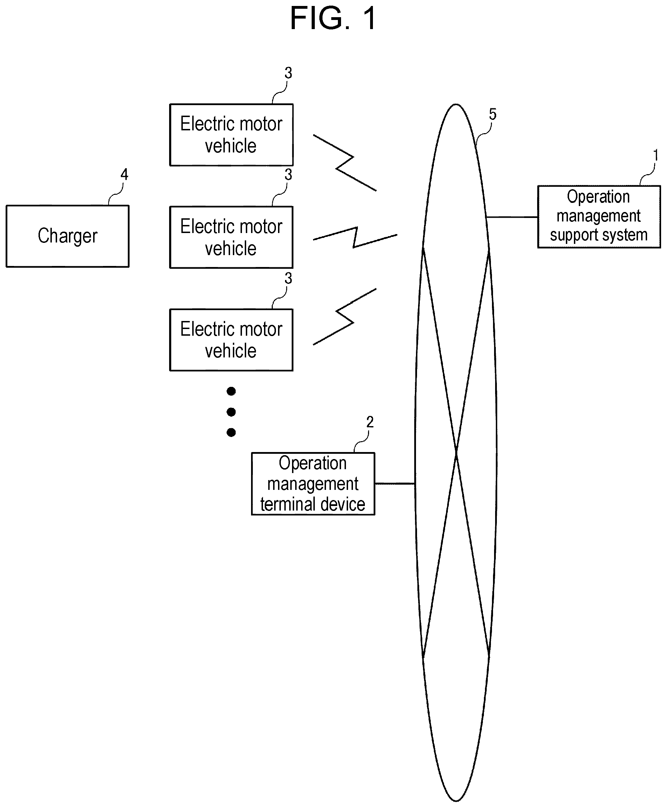

Fig. 1 is a diagram for describing an outline of operation management support system 1 according to an exemplary embodiment.

Operation management support system 1 according to the exemplary embodiment is a system that is used by at least one delivery company. Operation management support system 1 may be built on its own server located in a data center or in its own facility of a service-providing entity that provides an operation management support service for electric motor vehicles 3, for example. Operation management support system 1 may be built on a cloud server that is used on the basis of a cloud service. Furthermore, operation management support system 1 may be built on two or more servers at two or more dispersed locations (data centers or own facilities). The two or more servers may be any of a combination of two or more own servers, a combination of two or more cloud servers, and a combination of an own server and a cloud server.

The delivery company has a plurality of electric motor vehicles 3 and charger 4 and has a delivery center for parking electric motor vehicles 3. Operation management terminal device 2 is placed at the delivery center. Operation management terminal device 2 is a personal computer (PC), for example. Operation management terminal device 2 is used to manage the plurality of electric motor vehicles 3 that belong to the delivery center. Using operation management terminal device 2, an operation manager of the delivery company can create a delivery plan, a charging plan, etc., for the plurality of electric motor vehicles 3.

Operation management terminal device 2 can access operation management support system 1 via network 5. Operation management terminal device 2 can obtain battery state management information of the plurality of owned electric motor vehicles 3 from operation management support system 1.

Network 5 is a generic term of communication paths such as the Internet, a dedicated line, and a virtual private network (VPN); the communication medium, the protocol, etc., of network 5 are not limited. As the communication medium, a mobile network (cellular network), a wireless local area network (LAN), a wired LAN, a fiber optic network, an asymmetric digital subscriber line network, or a cable television (CATV) network can be used, for example. As the communication protocol, transmission control protocol (TCP)/internet protocol (IP), user datagram protocol (UDP)/IP, or Ethernet (registered trademark) can be used, for example.

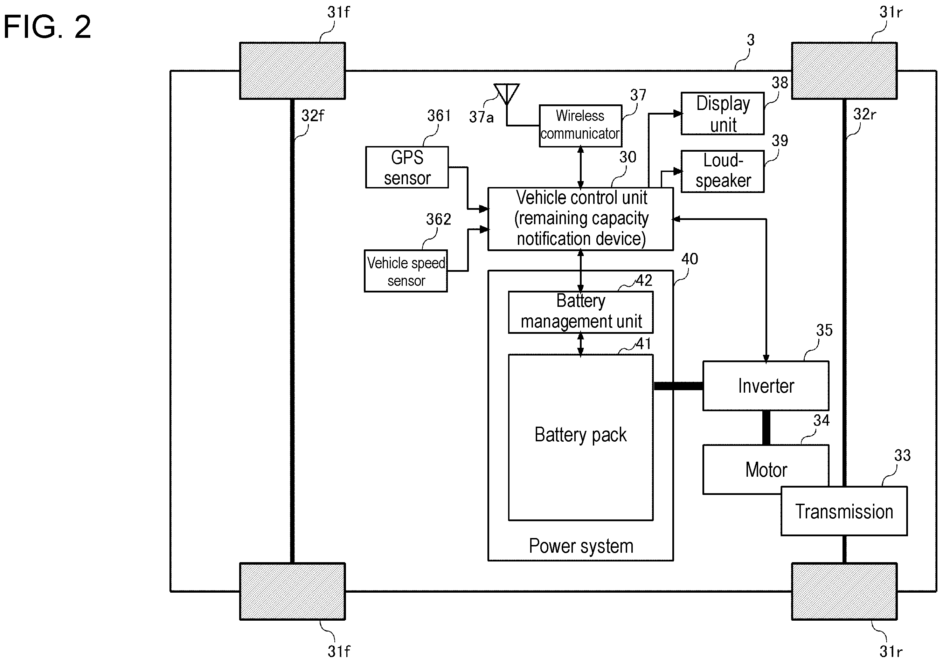

Fig. 2 is a diagram illustrating a schematic configuration of electric motor vehicle 3 according to the exemplary embodiment. The present exemplary embodiment assumes that electric motor vehicle 3 is a pure EV without an internal combustion engine. Electric motor vehicle 3 illustrated in Fig. 2 is a rear-wheel-drive (2WD) EV with a pair of front wheels 31f, a pair of rear wheels 31r, and motor 34 as a source of power. The pair of front wheel 31f are connected by front wheel shaft 32f, and the pair of rear wheels 31r are connected by rear wheel shaft 32r. Transmission 33 transmits the rotation of motor 34 to rear wheel shaft 32r at a predetermined conversion ratio. Note that electric motor vehicle 3 may be a front-wheel-drive (2WD) electric vehicle or may be a 4WD electric vehicle.

Power system 40 includes battery pack 41 and battery management unit 42, and battery pack 41 includes a plurality of cells. Lithium-ion battery cells, nickel-hydrogen battery cells, or the like can be used as said cells. Hereinafter, it is assumed, for example, that lithium-ion battery cells are used. Battery management unit 42 monitors the voltage, the electric current, the temperature, the SOC, the FCC, and the state of health (SOH) at each of the plurality of cells included in battery pack 41, and transmits these to vehicle control unit 30 via an in-vehicle network. As the in-vehicle network, a controller area network (CAN) or a local interconnect network (LIN) can be used, for example.

In EVs, a three-phase alternating-current motor is generally used as motor 34 for driving. Inverter 35 converts direct-current power supplied from battery pack 41 into alternating-current power and supplies the alternating-current power to motor 34 during power running. During regeneration, the alternating-current power supplied from motor 34 is converted into direct-current power and supplied to battery pack 41. Motor 34 rotates according to the alternating-current power supplied from inverter 35 during power running. During regeneration, rotational energy generated as a result of a reduction in speed is converted into alternating-current power and supplied to inverter 35.

Vehicle control unit 30 is a vehicle electronic control unit (ECU) that controls entire electric motor vehicle 3 and may include an integrated vehicle control module (VCM), for example.

GPS sensor 361 detects position information of electric motor vehicle 3 and transmits the detected position information to vehicle control unit 30. Specifically, GPS sensor 361 receives radio waves including respective time points of transmission from multiple GPS satellites and calculates the latitude and longitude of a point of receipt on the basis of multiple time points of transmission included in the multiple radio waves received.

Vehicle speed sensor 362 generates pulse signals that are proportional to the number of revolutions of front wheel shaft 32f or rear wheel shaft 32r, and transmits the generated pulse signals to vehicle control unit 30. Vehicle control unit 30 detects the speed of electric motor vehicle 3 on the basis of the pulse signals received from vehicle speed sensor 362.

Wireless communication unit 37 performs signal processing for wireless connection to network 5 via antenna 37a. As a wireless communication network to which electric motor vehicle 3 can be wirelessly connected, a mobile network (cellular network), a wireless LAN, vehicle-to-infrastructure (V2I), vehicle-to-vehicle (V2V), an electronic toll collection system (ETC system), dedicated short range communications (DSRC), or the like can be used, for example.

Display unit 38 is a display on which text, video, and the like can be displayed; a liquid-crystal display, an organic electroluminescent display, a mini light-emitting diode (LED) display, or the like can be used as display unit 38. Display unit 38 may be a display of a tablet device, a car navigation system, an in-dash receiver, a dashboard camera, or the like that is placed inside the vehicle or may be a display installed in an instrument panel. Furthermore, display unit 38 may be a display of a tablet device, a smartphone, or the like of a user that is in coordination with in-vehicle equipment.

Loudspeaker 39 outputs an audio message. Loudspeaker 39 may be a loudspeaker of a car navigation system, an in-dash receiver, a dashboard camera, or the like or may be an independent loudspeaker.

Vehicle control unit 30 can transmit travel data in real time from wireless communication unit 37 to operation management support system 1 via network 5 during travel of electric motor vehicle 3. The travel data includes the position data (latitude and longitude) of electric motor vehicle 3, the speed of electric motor vehicle 3, and the voltage, the electric current, the temperature, the SOC, and the SOH at each of the plurality of cells included in battery pack 41. Vehicle control unit 30 samples the data regularly (for example, at intervals of 10 seconds) and transmits the sampled data to operation management support system 1 accordingly.

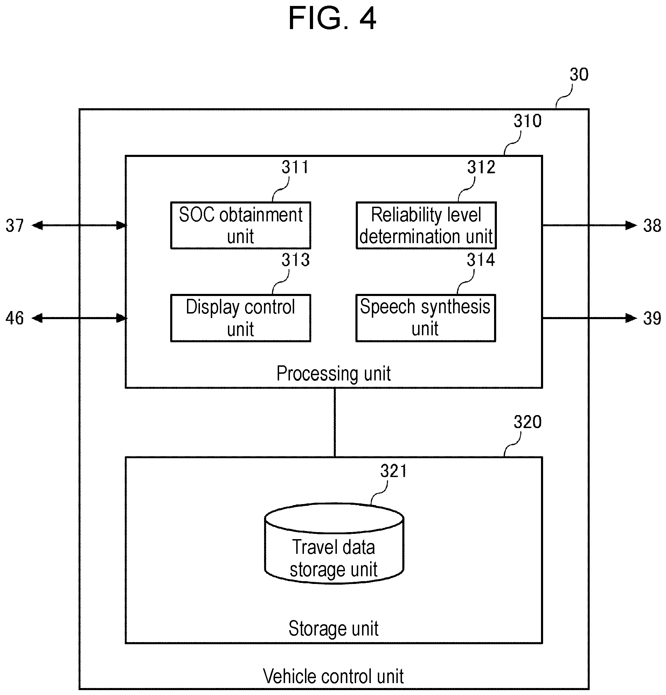

Note that vehicle control unit 30 may accumulate the travel data of electric motor vehicle 3 in travel data storage unit 321 provided therein (refer to Fig. 4) and transmit the collection of travel data accumulated in travel data storage unit 321 at a predetermined timing. For example, vehicle control unit 30 may transmit the collection of travel data accumulated in travel data storage unit 321 to operation management terminal device 2 placed at a center of a delivery company after the close of business day. Operation management terminal device 2 transmits the travel data of the plurality of electric motor vehicles 3 to operation management support system 1 at a predetermined timing.

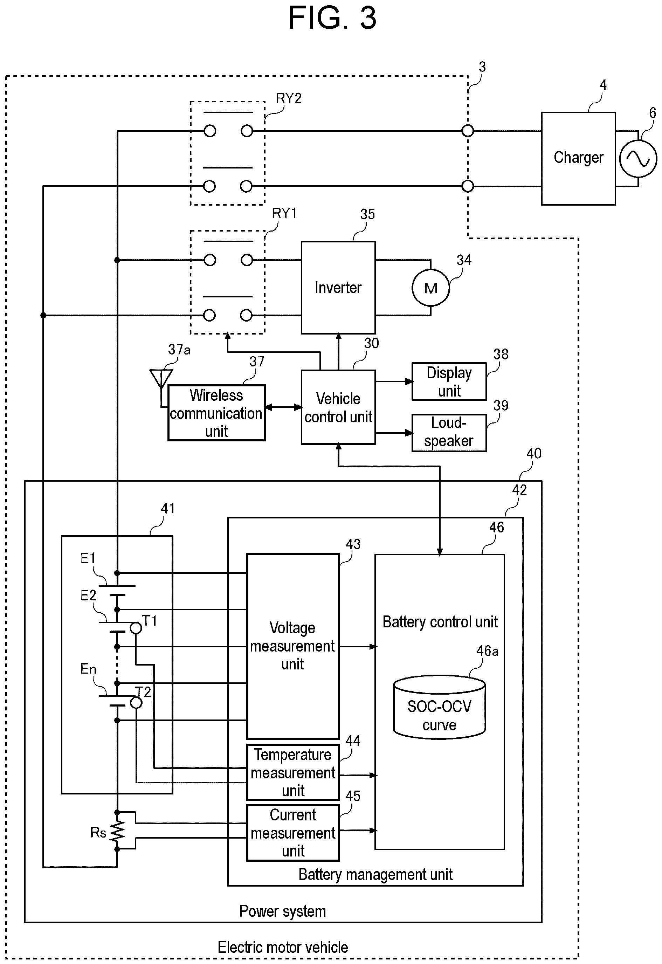

Fig. 3 is a diagram for describing a detailed configuration of power system 40 mounted in electric motor vehicle 3 according to the exemplary embodiment. Power system 40 is connected to motor 34 via first relay RY1 and inverter 35. First relay RY1 is a contactor that is inserted between wires connecting power system 40 and inverter 35. During travel, vehicle control unit 30 performs control such that first relay RY1 is in an ON state (closed state), causing power system 40 and a motive system of electric motor vehicle 3 to be electrically connected. During non-travel periods, vehicle control unit 30 basically performs control such that first relay RY1 is in an OFF state (open state), causing power system 40 and the motive system of electric motor vehicle 3 to be electrically disconnected. Note that instead of the relay, other types of switches such as a semiconductor switch may be used.

When electric motor vehicle 3 is connected to charger 4 using a charging cable, battery pack 41 included in power system 40 can be charged externally. Charger 4 is connected to commercially available electric power system 6 and charges battery pack 41 included in electric motor vehicle 3. In electric motor vehicle 3, second relay RY2 is inserted between wires connecting power system 40 and charger 4. Battery management unit 42 performs control directly or via vehicle control unit 30 before the start of charging such that second relay RY2 is placed in the ON state, and performs control directly or via vehicle control unit 30 after the end of charging such that second relay RY2 is placed in the OFF state.

Generally, an alternating current is used for normal charging, and a direct current is used for fast charging. When charging is performed using an alternating current (for example, 100/200V on a single phase), alternating-current power is converted into direct-current power by an AC/DC converter (not illustrated in the drawings) inserted between second relay RY2 and power system 40. In the case where charging is performed using a direct current, charger 4 generates direct-current power by performing full-wave rectification on the alternating-current power supplied from commercially available electric power system 6 and then performing smoothing thereon using a filter.

Battery pack 41 includes a plurality of cells E1 to En connected in series. The number of cells E1 to En connected in series is determined according to the drive voltage of motor 34. Note that battery pack 41 may be configured of a plurality of cell modules combined.

Shunt resistor Rs is connected in series to the plurality of cells E1 to En. Shunt resistor Rs functions as an electric current detection element. Note that a Hall element may be used instead of shunt resistor Rs. Furthermore, a plurality of temperature sensors T1, T2 for measuring the temperatures of the plurality of cells E1 to En are provided in battery pack 41. As temperature sensors T1, T2, thermistors can be used, for example.

Battery management unit 42 includes voltage measurement unit 43, temperature measurement unit 44, current measurement unit 45, and battery control unit 46. A plurality of voltage lines are connected between voltage measurement unit 43 and the respective nodes of the plurality of cells E1 to En connected in series. Voltage measurement unit 43 measures the voltage of each of cells E1 to En by measuring a voltage between two adjacent voltage lines. Voltage measurement unit 43 transmits the measured voltage of each of cells E1 to En to battery control unit 46.

Voltage measurement unit 43 and battery control unit 46 are connected by a communication line in the state where these are insulated from each other because voltage measurement unit 43 is at a higher voltage than battery control unit 46. Voltage measurement unit 43 can be configured using an application specific integrated circuit (ASIC) or a general-purpose analog front end IC. Voltage measurement unit 43 includes a multiplexer and an A/D converter. The multiplexer outputs the voltage between two adjacent voltage lines to the A/D converter in descending order. The A/D converter converts, into a digital value, an analog voltage that is input from the multiplexer.

Temperature measurement unit 44 includes a voltage-dividing resistor and an A/D converter. The A/D converter sequentially converts, into digital values, the plurality of analog voltages divided by the plurality of voltage-dividing resistors and the plurality of temperature sensors T1, T2, and outputs the digital values to battery control unit 46. Battery control unit 46 estimates the temperatures of the plurality of cells E1 to En on the basis of said digital values. For example, battery control unit 46 estimates the temperatures of cells E1 to En on the basis of measurement values of the temperature sensor that is most adjacent to cells E1 to En.

Current measurement unit 45 includes a differential amplifier and an A/D converter. The differential amplifier amplifies a voltage between both ends of shunt resistor Rs and outputs the voltage to the A/D converter. The A/D converter converts, into a digital value, the analog voltage that is input from the differential amplifier, and outputs the digital value to battery control unit 46. Battery control unit 46 estimates, on the basis of said digital value, an electric current flowing to the plurality of cells E1 to En.

Note that when an A/D converter is provided in battery control unit 46 and battery control unit 46 includes an analog input port, temperature measurement unit 44 and current measurement unit 45 may output the analog voltages to battery control unit 46, and the A/D converter included in battery control unit 46 may convert the analog voltages into digital values.

Battery control unit 46 manages the states of the plurality of cells E1 to En on the basis of the voltages, temperatures, and electric currents at the plurality of cells E1 to En that have been measured by voltage measurement unit 43, temperature measurement unit 44, and current measurement unit 45. A microcontroller and non-volatile memory (for example, electrically erasable programmable read-only memory (EEPROM) and flash memory) can be included in battery control unit 46. Battery control unit 46 estimates the SOC, the FCC, and the SOH of each of the plurality of cells E1 to En.

Battery control unit 46 estimates the SOC by a combination of the current integration method and the OCV method. The OCV method is a method for estimating an OCV from the voltage of each of cells E1 to En measured by voltage measurement unit 43, the temperature of each of cells E1 to En measured by temperature measurement unit 44, and the electric current at each of cells E1 to En measured by current measurement unit 45, and estimating a SOC on the basis of the estimated OCV and the SOC-OCV curve of cells E1 to En. The OCV is a voltage component obtained by removing a polarization voltage from a measured voltage; therefore, even during charging or discharging, it is possible to calculate the SOC based on the OCV method by estimating the polarization voltage from the electric current, the temperature, the SOH, and the like. The SOC-OCV curve of cells E1 to En is created in advance on the basis of a property test conducted by a battery manufacturer and is registered in internal memory of the microcomputer at the time of shipment.

The current integration method is a method for estimating a SOC on the basis of the OCV of each of cells E1 to En measured at the start of charging or discharging and the integrated value of electric currents measured by current measurement unit 45. Specifically, SOCi in the current integration method is calculated according to the following (Expression 1).

$$\text{SOCi} = \text{SOCv at the start of charging or discharging} \pm (\text{integrated current value} / \text{FCC}) \ldots \text{(Expression 1)}$$

In the current integration method, errors of measurement by current measurement unit 45 are accumulated as charging or discharging time increases. Meanwhile, the OCV method is subject to errors of measurement by voltage measurement unit 43 and errors due to the polarization voltage. Therefore, battery control unit 46 may estimate a SOC by calculating a weighted average of the SOCi estimated by the current integration method and the SOCv estimated by the OCV method, as indicated in the following (Expression 2).

$$\text{SOC} = \text{SOCi} * x + \text{SOCv} * (1 - x) \ldots \text{(Expression 2)}$$

In the expression, x denotes a contribution; for example, x is set so as to approach 1 during charging or discharging and approach 0 during downtime. Note that the SOCi measured during charging or discharging may be corrected by a method other than the weighted average method in which the SOCv is used, and the corrected SOCi may be applied as the SOC measured during charging and discharging.

Battery control unit 46 can estimate the FCC on the basis of the integrated value of electric currents measured at two points and the difference between two SOCvs corresponding to two OCVs measured before the start of charging or discharging and after the end of charging or discharging, as indicated in the following (Expression 3).

$$\text{FCC} = \text{Integrated current value} / \Delta \text{SOCv} \ldots \text{(Expression 3)}$$

The SOH is defined by the ratio of the current FCC to the initial FCC; a SOH with a lower numerical value (closer to 0%) indicates more advanced degradation. Battery control unit 46 can estimate the SOH on the basis of the initial FCC and the current FCC, as indicated in the following (Expression 4).

$$\text{SOH} = \text{Current FCC} / \text{Initial FCC} \ldots \text{(Expression 4)}$$

Battery control unit 46 estimates the SOC, the FCC, and the SOH of battery pack 41 on the basis of the SOC, the FCC, and the SOH of each of the plurality of cells E1 to En. Battery control unit 46 transmits the voltage, the electric current, the temperature, the SOC, the FCC, and the SOH of battery pack 41 and each of cells E1 to En to vehicle control unit 30 via the in-vehicle network.

Vehicle control unit 30 can estimate a cruising distance on the basis of a cruising distance coefficient and the SOC of battery pack 41, as indicated in the following (Expression 5) to (Expression 7).

$$\text{Cruising distance} = \text{SOC} \times \text{Cruising distance coefficient} \ldots \text{(Expression 5)}$$

$$\text{Cruising distance coefficient} = \Delta\text{Travel distance} / \Delta\text{SOCv} \ldots \text{(Expression 6)}$$

$$\Delta\text{SOCv} = \text{SOCv before travel} - \Delta\text{SOCv after travel} \ldots \text{(Expression 7)}$$

Fig. 4 is a diagram for describing the configuration of vehicle control unit 30. Vehicle control unit 30 includes processing unit 310 and storage unit 322. Processing unit 310 includes SOC obtainment unit 311, reliability level determination unit 312, display control unit 313, and speech synthesis unit 314. Note that only function blocks related to a remaining current capacity notification process on which the present exemplary embodiment focuses are illustrated in processing unit 310.

The functions of processing unit 310 can be implemented by the coordination of a hardware resource and a software resource or can be implemented by a hardware resource only. As the hardware resource, a central processing unit (CPU), read-only memory (ROM), random-access memory (RAM), a graphics processing unit (GPU), an application specific integrated circuit (ASIC), a field programmable gate array (FPGA), and other LSI can be used. As the software resource, an operating system and a program such as an application can be used.

Storage unit 320 includes travel data storage unit 321. Storage unit 320 includes a non-volatile recording medium such as a hard disk drive (HDD) and a solid-state disk (SSD) and stores various data. Travel data storage unit 321 holds travel data including the voltage, the electric current, the temperature, the SOC, the FCC, and the SOH of each of cells E1 to En and battery pack 41 that have been received from battery control unit 46, and the position data, the speed, the integrated travel distance, etc., of electric motor vehicle 3 that have been obtained from the various sensors included in electric motor vehicle 3.

SOC obtainment unit 311 obtains, from battery control unit 46, the SOC of battery pack 41 that indicates a remaining battery capacity for notifying an occupant (mainly a driver) in electric motor vehicle 3 (hereinafter referred to as the presented SOC). Note that the presented SOC can be estimated in operation management support system 1. In this case, SOC obtainment unit 311 receives the presented SOC from operation management support system 1 via network 5.

Reliability level determination unit 312 determines the reliability level of the presented SOC on the basis of the slope of the SOC-OCV curve that corresponds to said presented SOC. Reliability level determination unit 312 evaluates the reliability level of the presented SOC as being higher as the slope of the SOC-OCV curve that corresponds to the presented SOC increases. The slope of the SOC-OCV curve can be defined by the differential curve of the SOC-OCV curve. The differential curve of the SOC-OCV curve is used as a remaining battery capacity reliability level curve.

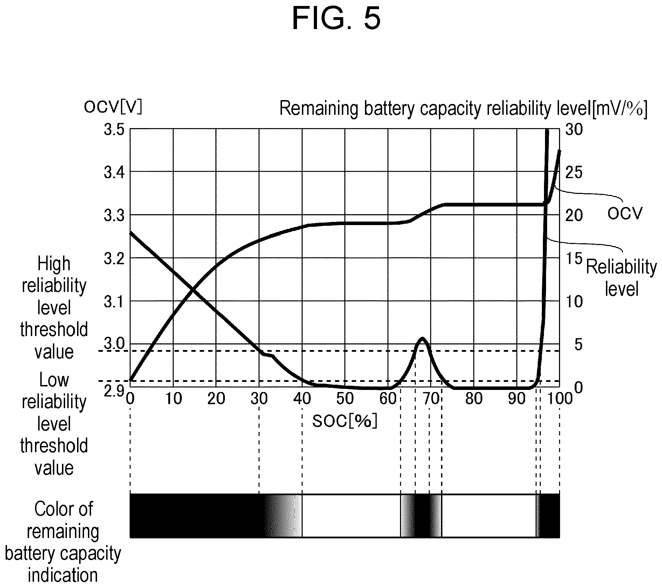

Fig. 5 is a diagram illustrating one example of the SOC-OCV curve and the remaining battery capacity reliability level curve. Fig. 5 illustrates the SOC-OCV curve and the remaining battery capacity reliability level curve of one lithium ferro phosphate (LFP) battery. As illustrated in Fig. 5, a high reliability level threshold value and a low reliability level threshold value are set for the remaining battery capacity reliability level. A region having values greater than the high reliability level threshold value (hereinafter referred to as the high reliability level region) is where the reliability level of the SOCv estimated by the OCV method is high, and a region having values less than the low reliability level threshold value (hereinafter referred to as the low reliability level region) is where the reliability level of the SOCv is low. A region having values greater than or equal to the low reliability level threshold value, but less than the high reliability level threshold value (hereinafter referred to as the moderate reliability level region) is where the reliability level of the SOCv is moderate.

Display control unit 313 performs control such that the remaining battery capacity is displayed on display unit 38 in a display mode based on the reliability level of the presented SOC that has been determined by reliability level determination unit 312. More specifically, display control unit 313 performs control such that the remaining battery capacity is displayed on display unit 38 more conspicuously as the reliability level of the presented SOC increases.

Display control unit 313 controls the color of indication of the remaining battery capacity such that the remaining battery capacity is displayed in a first color when the remaining battery capacity reliability level is in the high reliability level region, is displayed in a second color when the remaining battery capacity reliability level is in the low reliability level region, and is displayed in a color at a gradation level between the first color and the second color when the remaining battery capacity reliability level is in the moderate reliability level region, for example. The first color may be a light color, and the second color may be a deep color; for example, the first color may be green, and the second color may be blue. In the moderate reliability level region, the gradation level changes in proportion to the remaining battery capacity reliability level. Note that when a monochrome display is used as display unit 38, the first color is white, the second color is black, and the moderate reliability level region is shown in grayscale.

In the example illustrated in Fig. 5, when the high reliability level threshold value and the low reliability level threshold value are set, the range of the OCV to be shown at gradation levels is narrowed. Thus, it is possible to prevent a change in the color of indication with respect to a small change in the OCV from becoming a subtle change that cannot be visually recognized by a user. Note that display control unit 313 may simply control the color of indication of the remaining battery capacity such that the remaining battery capacity is displayed in the first color when the remaining battery capacity reliability level is in the high reliability level region, and is displayed in the second color when the remaining battery capacity reliability level is out of the high reliability level region.

As mentioned above, the SOCv estimated by the OCV method is subject to effects of diffusion polarization. After charging or discharging of battery pack 41 stops, it takes a long time until the polarization is removed and the measured voltage values converge to the OCV. Therefore, after electric motor vehicle 3 stops traveling or after charging from charger 4 stops, time elapsed since the stop (hereinafter referred to as downtime) also has impact on the reliability level of the presented SOC.

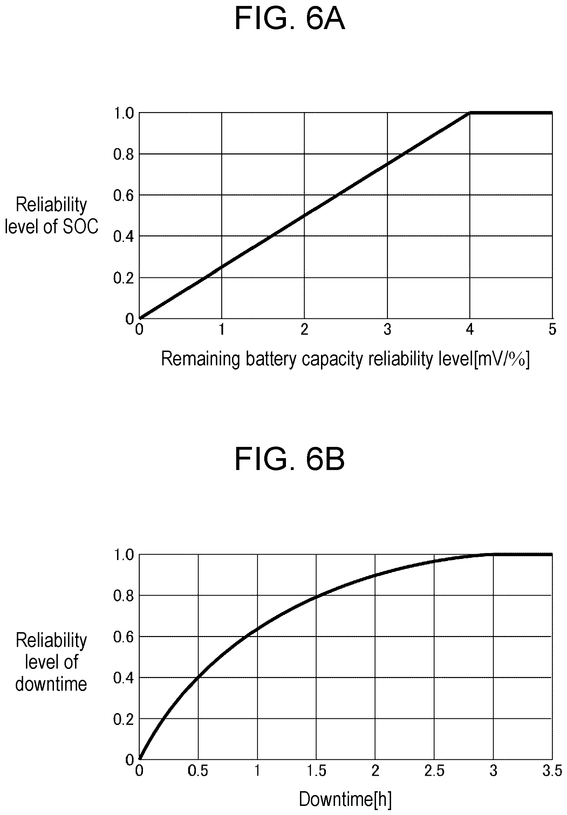

Fig. 6A and Fig. 6B are diagrams each illustrating one example of a reliability level conversion map which is used to calculate a comprehensive SOC reliability level based on the remaining battery capacity reliability level and the downtime. Fig. 6A is a map for converting the remaining battery capacity reliability level illustrated in Fig. 5 into a normalized reliability level. The normalized reliability level of the SOC is in the range of 0 to 1; the normalized reliability level of the SOC that is closer to 1 represents a higher reliability level. Fig. 6B is a map for converting downtime into a normalized reliability level. The normalized reliability level of the downtime is in the range of 0 to 1; the normalized reliability level of the downtime that is closer to 1 represents a higher reliability level. Note that the characteristics of the reliability level curve of the downtime largely depend on the material used for the electrode of the cell. Fig. 6B shows an example where the polarization voltage is eliminated from the measured voltage over the course of a three-hour pause.

Reliability level determination unit 312 can calculate reliability level Rsoc of the presented SOC by calculating a weighted average of reliability level Rsoci of the SOCi estimated by the current integration method and reliability level Rsocv of the SOCv estimated by the OCV method, as indicated in the following (Expression 8). When calculating a weighted average of two reliability levels Rsoci and Rsocv, downtime reliability level Rrest is used as a contribution of reliability level Rsocv of the SOCv.

$$Rsoc = Rsoci*(1 - Rrest) + Rsocv*Rrest \ldots \text{(Expression 8)}$$

The map illustrated in Fig. 6B is an example in which the contribution of the SOCv estimated by the OCV method reaches 0 (the SOCi estimated by the current integration method is directly used as the presented SOC) during travel or during charging, but the SOCv estimated by the OCV method may have a predetermined contribution even during travel or during charging.

Reliability level determination unit 312 calculates a remaining battery capacity reliability level on the basis of the SOCi estimated by the current integration method and the SOC-OCV curve (refer to Fig. 5), and calculates reliability level Rsoci of the SOCi on the basis of the calculated remaining current capacity reliability level (refer to Fig. 6A). Reliability level determination unit 312 calculates a remaining battery capacity reliability level on the basis of the SOCv estimated by the OCV method and the SOC-OCV curve (refer to Fig. 5), and calculates reliability level Rsocv of SOCv on the basis of the calculated remaining current capacity reliability level (refer to Fig. 6A).

Reliability level determination unit 312 calculates downtime reliability level Rrest on the basis of the downtime of battery pack 41 (refer to Fig. 6B). Reliability level determination unit 312 calculates reliability level Rsoc of the presented SOC on the basis of reliability level Rsoci of the SOCi, reliability level Rsocv of the SOCv, and downtime reliability level Rrest (refer to (Expression 8)). Reliability level determination unit 312 calculates a remaining battery capacity reliability level on the basis of the presented SOC calculated and the SOC-OCV curve (refer to Fig. 5). Display control unit 313 performs control such that the remaining battery capacity corresponding to the presented SOC is displayed on display unit 38 in a display mode corresponding to the remaining battery capacity reliability level calculated.

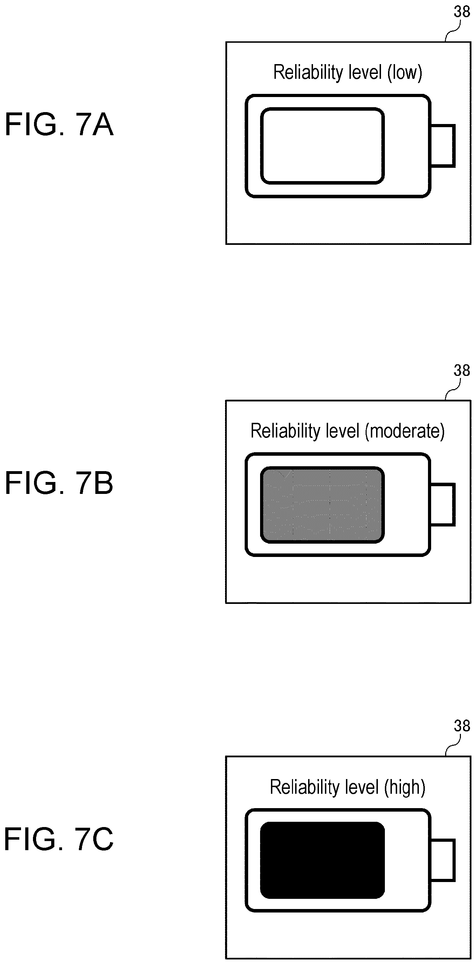

Fig. 7A to Fig. 7C each illustrate a display example of the remaining battery capacity displayed on display unit 38 of electric motor vehicle 3. Fig. 7A illustrates a display example of when the remaining battery capacity reliability level is in the low reliability level region, Fig. 7B illustrates a display example of when the remaining battery capacity reliability level is in the moderate reliability level region, and Fig. 7C illustrates a display example of when the remaining battery capacity reliability level is in the high reliability level region.

During travel or charging of electric motor vehicle 3, the color of indication of the remaining battery capacity changes mainly according to a change in the presented SOC that accompanies a change in the SOCi. While electric motor vehicle 3 is not in motion, the color of indication of the remaining battery capacity changes according to a change in the presented SOC that accompanies a change in the SOCv. When the polarization is removed, the presented SOC stops changing.

For example, when electric motor vehicle 3 stops while the remaining battery capacity indication has the second color (for example, blue) and the remaining battery capacity indication still has the second color even while electric motor vehicle 3 is not in motion, this means that the SOCi error is small. In contrast, when electric motor vehicle 3 stops while the remaining battery capacity indication has the second color and the remaining battery capacity indication changes into the first color (for example, green) while electric motor vehicle 3 is not in motion, this means that the SOCi error is significant. In other words, there may be a deviation in the FCC or the like that is a parameter required to estimate the SOCi.

When electric motor vehicle 3 stops while the remaining battery capacity indication has the first color and the remaining battery capacity indication still has the first color even while electric motor vehicle 3 is not in motion, this means that the SOCi error is small. However, the measurement error of voltage measurement unit 43 has significant impact on this result. In contrast, when electric motor vehicle 3 stops while the remaining battery capacity indication has the first color and the remaining battery capacity indication changes into the second color while electric motor vehicle 3 is not in motion, this means that the SOCi error is significant. In other words, there may be a deviation in the FCC or the like that is a parameter required to estimate the SOCi.

Note that the remaining battery capacity indication may reflect only the length of downtime after electric motor vehicle 3 stops. In this case, display control unit 313 displays the remaining battery capacity indication in the first color when electric motor vehicle 3 stops traveling and, as the downtime increases, changes the remaining battery capacity indication so that the color thereof approaches the second color. Similar control may be performed after charging from charger 4 stops.

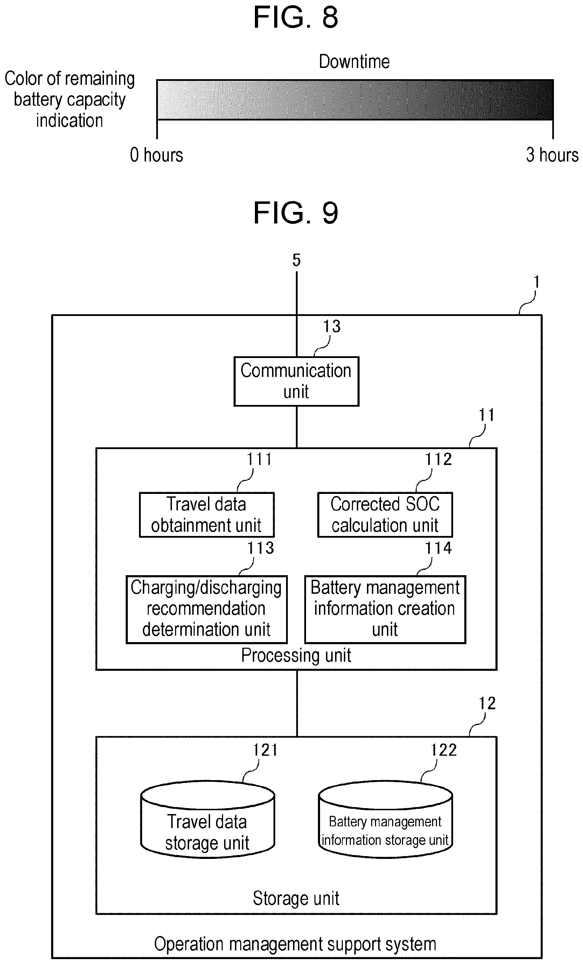

Fig. 8 is a diagram illustrating the association between the length of downtime and the color of the remaining battery capacity indication when the remaining battery capacity indication reflects only the length of downtime. In this case, by referring to the color of the remaining battery capacity indication, a user can check, in addition to the reliability level of the remaining battery capacity, time elapsed from when electric motor vehicle 3 stops traveling or when charging from charger 4 stops.

The discussion returns to Fig. 4. Speech synthesis unit 314 causes loudspeaker 39 to output audio of the remaining battery capacity notification message that reflects the reliability level of the presented SOC that has been determined by reliability level determination unit 312. For example, when electric motor vehicle 3 stops traveling, speech synthesis unit 314 causes loudspeaker 39 to output audio indicating the numerical value of the presented SOC that indicates the remaining battery capacity, and the numerical value, the classification level, etc., of the reliability level of the presented SOC (refer to Fig. 6A). Note that it is sufficient that at least one of display control unit 313 and speech synthesis unit 314 be included; at least one of these may be omitted.

Fig. 9 is a diagram for describing operation management support system 1 according to the exemplary embodiment. Operation management support system 1 includes processing unit 11, storage unit 12, and communication unit 13. Communication unit 13 is a communication interface for wired or wireless connection to network 5.

Processing unit 11 includes travel data obtainment unit 111, corrected SOC calculation unit 112, charging/discharging recommendation determination unit 113, and battery management information generation unit 114. The functions of processing unit 11 can be implemented by the coordination of a hardware resource and a software resource or can be implemented by a hardware resource only. As the hardware resource, a CPU, ROM, RAM, a GPU, an ASIC, a FPGA, and other LSI can be used. As the software resource, an operating system and a program such as an application can be used.

Storage unit 12 includes travel data storage unit 121 and battery management information storage unit 122. Storage unit 12 includes a non-volatile recording medium such as HDD and SSD and stores various data. Travel data obtainment unit 111 obtains travel data from each electric motor vehicle 3 via network 5 and accumulates the travel data in travel data storage unit 121.

First, a voltage margin is set to the worst value of lower offset error of a voltage sensor used as voltage measurement unit 43. Corrected SOC calculation unit 112 calculates a lower limit SOC by subtracting the voltage margin from the SOCv based on the OCV method. Corrected SOC calculation unit 112 calculates a SOC error by subtracting the lower limit SOC from the presented SOC. The SOC error is desirably calculated when the downtime reliability level is greater than or equal to a set value (for example, 0.67).

Note that the SOCv based on the OCV method and the presented SOC may be obtained from vehicle control unit 30 of electric motor vehicle 3 or may be calculated on the operation management support system 1. In the case where these are calculated on the operation management support system 1, it is necessary to prepare the SOC-OCV curve of cells E1 to En included in battery pack 41 mounted in each electric motor vehicle 3. This SOC-OCV curve may be prepared on the basis of catalog values provided by the battery manufacturer or may be generated on the basis of battery data collected from each electric motor vehicle 3. In the latter case, the SOC-OCV curve may be generated for each electric motor vehicle 3 or may be generated for corresponding vehicle type.

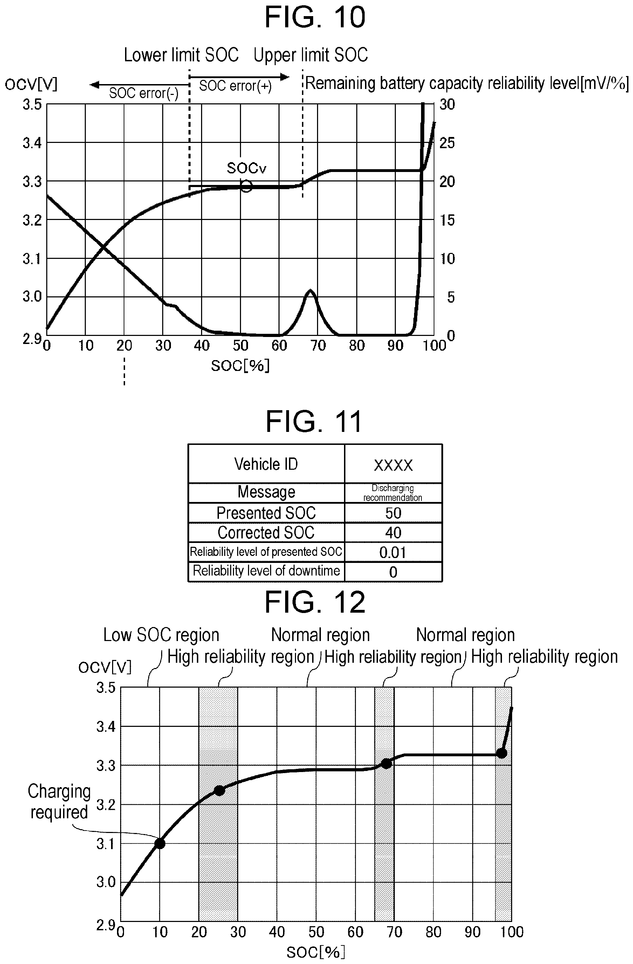

Fig. 10 is a diagram illustrating a specific example of the SOCv, the lower limit SOC, and the SOC error based on the OCV method. Corrected SOC calculation unit 112 calculates a corrected SOC by subtracting the SOC error from the presented SOC. Charging/discharging recommendation determination unit 113 recommends charging when the corrected SOC is less than a low SOC threshold value (that is 20% in Fig. 10), and recommends discharging when the corrected SOC is greater than or equal to the low SOC threshold value.

Battery management information generation unit 114 generates battery management information for each battery pack 41 mounted in electric motor vehicle 3 and stores the battery management information into battery management information storage unit 122.

Fig. 11 is a diagram illustrating a format example of the battery management information. In the format illustrated in Fig. 11, vehicle ID, a message (charging recommendation/discharging recommendation), a presented SOC, a corrected SOC, a reliability level of the presented SOC, and a downtime reliability level are managed as the battery management information.

Using operation management terminal device 2, the operation manager of the delivery company can refer to the battery management information of the plurality of electric motor vehicles 3 owned by the delivery company that has been generated by operation management support system 1. The operation manager can create a delivery plan and a charging plan on the basis of the battery management information of the plurality of electric motor vehicles 3. In order to avoid the risk of no more battery of electric motor vehicle 3, the operation manager prompts the driver of electric motor vehicle 3 to which a charging recommendation has been issued to quickly charge electric motor vehicle 3.

The operation manager creates a delivery plan and a charging plan for each electric motor vehicle 3 such that electric motor vehicle 3 is not in motion for a long time in the state where the SOC of battery pack 41 of electric motor vehicle 3 is in the high reliability level region. Specifically, the operation manager creates a delivery plan and a charging plan such that an expected SOC value after the delivery is completed or after the charging is completed falls within the high reliability level region. Note that the expected SOC value after the delivery is completed or after the charging is completed is calculated in view of the aforementioned SOC error.

Note that the delivery plan and the charging plan may be automatically created according to a predetermined operation management program. This operation management program may have been installed in operation management terminal device 2 or may have been installed in operation management support system 1. In the latter case, operation management terminal device 2 can download, from operation management support system 1, an operation management table of the plurality of electric motor vehicles 3 owned by the own company.

Fig. 12 is a diagram for describing one example of a basic algorithm for operation management. In the example illustrated in Fig. 12, the low SOC region is set to the range of 0 to 20%. Electric motor vehicle 3 including battery pack 41 with the SOC in the low SOC region needs to be charged. At this time, a charging rate and charging time are determined so that the SOC after the charging is completed falls within the high reliability level region. For electric motor vehicle 3 including battery pack 41 with the SOC out of the low SOC region, a delivery route is determined so that the SOC after the delivery is completed falls within the high reliability level region.

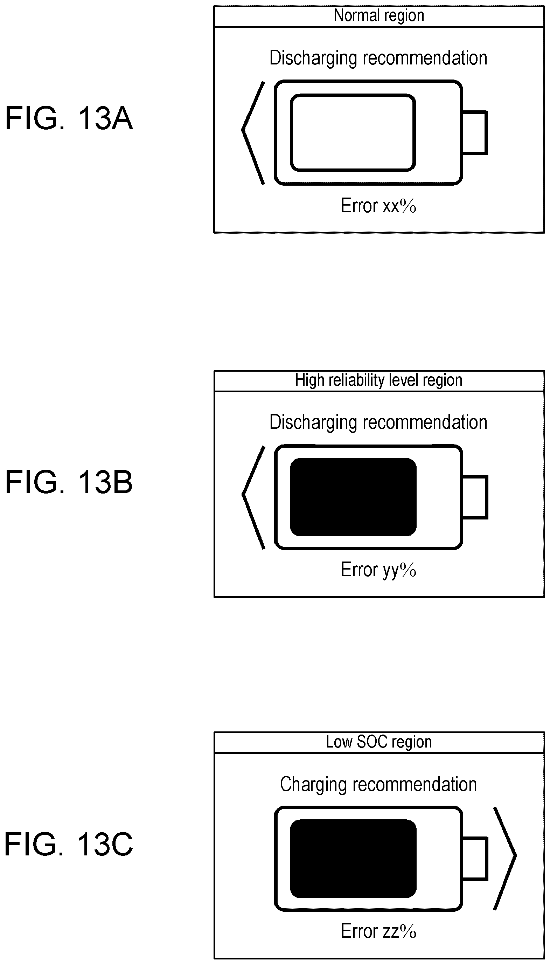

Fig. 13A to Fig. 13C each illustrate a display example of the remaining battery capacity displayed on operation management terminal device 2. Fig. 13A illustrates a display example of when the remaining battery capacity reliability level is in the normal reliability level region, Fig. 13B illustrates a display example of when the remaining battery capacity reliability level is in the high reliability level region, and Fig. 13C illustrates a display example of when the remaining battery capacity reliability level is in the low SOC region. In each of these figures, the discharging recommendation/the charging recommendation and the maximum error between the presented SOC and the SOCv are displayed.

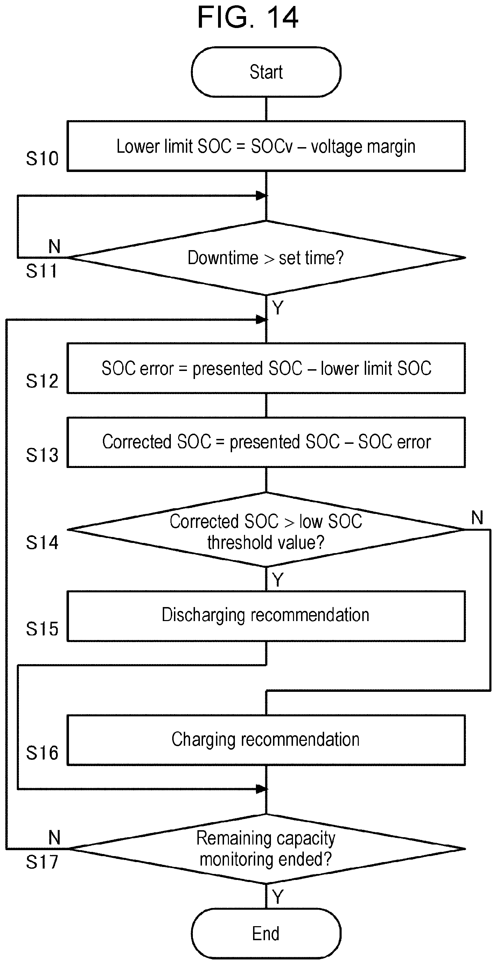

Fig. 14 is a flowchart illustrating the flow of discharging recommendation/charging recommendation determination processes for battery pack 41 mounted in electric motor vehicle 3 that is performed by operation management support system 1 according to the exemplary embodiment. Corrected SOC calculation unit 112 calculates a lower limit SOC by subtracting the voltage margin (the maximum lower offset error of the voltage sensor) from the SOCv based on the OCV method (S10). When the downtime of battery pack 41 exceeds the set time (for example, one hour) (Y in S 11), corrected SOC calculation unit 112 calculates a SOC error by subtracting the lower limit SOC from the presented SOC which has been calculated to be presented in the vehicle (S12). Corrected SOC calculation unit 112 calculates a corrected SOC by subtracting the SOC error from the presented SOC (S13).

Charging/discharging recommendation determination unit 113 compares the SOC error and the low SOC threshold value (for example, 20%) (S14). When the SOC error is greater than or equal to the low SOC threshold value (Y in S14), charging/discharging recommendation determination unit 113 determines that a discharging recommendation is to be issued to current electric motor vehicle 3 (S15). When the SOC error is less than the low SOC threshold value (N in S14), charging/discharging recommendation determination unit 113 determines that a charging recommendation is to be issued to current electric motor vehicle 3 (S16).

While the remaining capacity of battery pack 41 of electric vehicle 3 is being continuously monitored (N in S17), the processing transitions to Step S12, and the processes from Step S12 to Step S16 are repeatedly performed. Note that the presented SOC changes according to the length of the downtime as mentioned above.

As described above, according to the present exemplary embodiment, qualitative information visually indicating a reliability level is added to the remaining battery capacity indication, and thus users can naturally learn how to find and reset the SOC error in day-today operation. Specifically, in a region in which the SOC-OCV curve has a large slope (the high reliability level region of the SOC), the remaining battery capacity indication is displayed in a conspicuous color, and thus a user can be made aware that the electric motor vehicle is to remain stationary or be packed for a long time in the non-flat region of the SOC-OCV curve.

Furthermore, as illustrated in Fig. 5 described above, remaining battery capacity reliability levels greater than or equal to the high reliability level threshold value are regarded as equivalent, and thus local peaks of a lithium ferro phosphate (LFP) battery such as that near 70% in the SOC can be highlighted.

In the high reliability level region, an accurate SOCv can be estimated. The SOCv is a parameter required to calculate the SOCi, the presented SOC, the FCC, the ΔSOCv, the cruising distance coefficient, and the cruising distance (refer to (Expression 1) to (Expression 7) indicated above), meaning that when the accuracy of the SOCv is high, the accuracy of each of these parameters is also high. Conversely, when the accuracy of the SOCv is low, the accuracy of each of these parameters is also low.

For example, in electric vehicle 3 including a lithium ferro phosphate (LFP) battery, there may be cases where a short cruising distance is displayed in wintertime. In wintertime, the diffusion polarization in the lithium ferro phosphate (LFP) battery develops and lasts for a long time, and therefore the SOCv after travel is estimated to be low. Specifically, the OCV after travel is lower than a true OCV due to the diffusion polarization, and the ΔSOCv measured is large. Accordingly, the cruising distance coefficient and the estimated cruising distance value are reduced (refer to (Expression 5) to (Expression 7) indicated above). Furthermore, since the accuracy of the SOCv is reduced in the flat region of the SOC-OCV curve, there are cases where the actual cruising distance and the estimated cruising distance value are significantly different in the flat region of the SOC-OCV curve.

Regarding this issue, vehicle manufacturers advise that resetting to a correct cruising distance is possible when a vehicle remains stationary for a long time in the low SOC region, then is fully charged, and remains stationary for at least a predetermined length of time. Thus, it is possible to properly reset various parameters by making a significant change in the SOC in the high reliability level region of the SOC.

However, requesting users to perform an operation that requires lengthy charging and discharging, etc., results in reduced convenience for users. When a user makes a habit of allowing electric motor vehicle 3 to be stationary in a region in which the SOC error is small, it is possible to greatly reduce the likelihood that a significant error occurs in the cruising distance indication.

Furthermore, in the present exemplary embodiment, the operation manager of the delivery company can be notified of quantitative, specific battery management information (for example, the reliability level of the SOC, the SOC error, and the charging recommendation/discharging recommendation). When the SOC is low, users can be prompted to charge the vehicles to avoid unexpected no more battery. When the SOC is not low, users can be prompted to travel (discharge) until the SOC falls within the low SOC region. This improves the accuracy of operation and management, contributing to a more efficient delivery service.

The present disclosure has been described thus far based on the exemplary embodiment. The exemplary embodiment is merely an example; it will be understood by a person having ordinary skill in the art that various variations are possible as a combination of these structural elements and these processes and that these variations are also included in the scope of the present disclosure.

The SOC-OCV curve described above depends on the temperature and the SOH. Therefore, it is desirable to use the SOC-OCV curve corrected using a temperature map and a SOH map. The same applies to the convergence curve of polarization.

In the above-described exemplary embodiment, display control unit 313 displays a remaining battery capacity pictogram in a deeper color on display unit 38 as the reliability level of the presented SOC increases. Regarding this feature, as the reliability level of the presented SOC increases, the remaining battery capacity pictogram may be increased in size. Furthermore, as the reliability level of the presented SOC increases, the remaining battery capacity pictogram may flash more rapidly. As the reliability level of the presented SOC increases, the pattern of the remaining battery capacity pictogram may be increased in density. In addition, a mark (a thumbs-up sign, a thumbs-down sign, etc.) indicating the remaining battery capacity reliability level may be displayed near the remaining battery capacity indication. A numerical value indicating the remaining battery capacity reliability level may be displayed as it is near the remaining battery capacity indication.

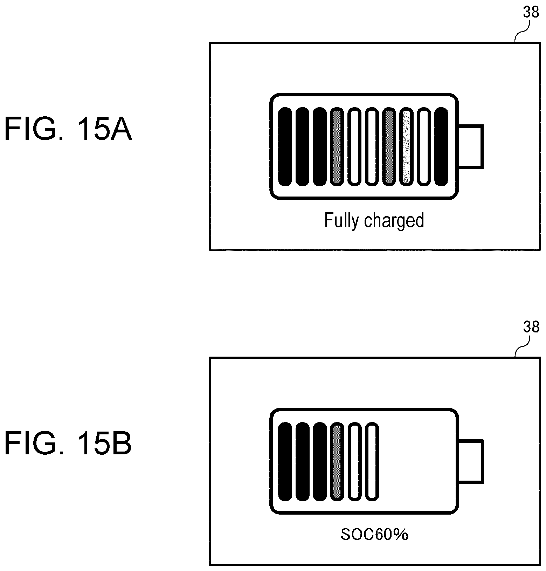

Fig. 15A and Fig. 15B are diagrams each illustrating another display example of the remaining battery capacity displayed on display unit 38 of electric motor vehicle 3. In this display example, the SOC is displayed in the form of bars at x% increments. In the example illustrated in Fig. 15A and Fig. 15B, a maximum of ten bars are displayed at SOC 10% increments; the number of bars increases or decreases by one for every 10% increase or decrease. In other words, the number of bars changes according to the current presented SOC, and the color of each bar displayed does not change according to elements other than the current presented SOC. The color of each bar to be displayed is determined by applying a high reliability level threshold value and a low reliability level threshold value such as those illustrated in Fig. 5, on the basis of a representative value (for example, the average value) of the remaining battery capacity reliability level in each SOC segment at x% increments.

The above-described exemplary embodiment has assumed that electric motor vehicle 3 is a four-wheel electric vehicle including inverter 35. In this regard, electric motor vehicle 3 may be an electric motorcycle (an electric scooter), an electric bicycle, or the like. Examples of the electric vehicle include not only standard electric vehicles, but also low-speed electric vehicles such as golf carts and land cars that are used in shopping malls, entertainment facilities, and the like.

The remaining battery capacity notification according to the present disclosure can also be applied to a device including battery pack 41 other than electric motor vehicle 3. For example, the remaining battery capacity notification according to the present disclosure can also be applied to electronic devices such as laptop computers and home appliances such as vacuum cleaners. In these devices, there are also cases where parameters such as the FCC are deviated due to usage; it is beneficial that users naturally learn how to find and reset the SOC error.

Note that the exemplary embodiment may be specified according to the following items.

[Item 1]

A remaining capacity notification device (30) for notifying a user of a device (3) of a remaining capacity of a secondary battery (41) mounted in the device (3), the remaining capacity notification device including:

a reliability level determination unit (312) that determines a reliability level of a SOC on the basis of a slope of a SOC-OCV curve of the secondary battery (41), the SOC representing a state of charge and indicating the remaining capacity of the secondary battery (41) that the user is to be notified of, the slope corresponding to the SOC, the OCV representing an open circuit voltage; and
a notification control unit (313, 314) that performs control to cause the user to be notified of the remaining capacity of the secondary battery (41) in a form of notification based on the reliability level of the SOC that has been determined.

This allows the user to naturally learn how to find and reset a SOC error in normal operation.

[Item 2]

The remaining capacity notification device (30) according to item 1, wherein the reliability level determination unit (312) evaluates the reliability level of the SOC indicating the remaining capacity that the user is to be notified of, as being higher, as the slope of the SOC-OCV curve that corresponds to the SOC indicating the remaining capacity that the user is to be notified of increases.

With this, it is possible to quantitatively understand the reliability level of the SOC.

[Item 3]

The remaining capacity notification device (30) according to item 2, wherein the notification control unit (313, 314) performs control to cause the remaining capacity of the secondary battery (41) to be displayed or audibly output more conspicuously as the reliability level of the SOC that has been determined increases.

With this, a user can be left with the impression of a region in which the reliability level of the SOC is high.

[Item 4]

The remaining capacity notification device (30) according to item 2 or 3, wherein the notification control unit (313, 314) performs control to (i) cause the remaining capacity of the secondary battery (41) to be displayed in a first color when the slope of the SOC-OCV curve that corresponds to the SOC indicating the remaining capacity that the user is to be notified of is less than a low reliability level threshold value, (ii) cause the remaining capacity of the secondary battery (41) to be displayed in a second color when the slope of the SOC-OCV curve is greater than or equal to a high reliability level threshold value, and (iii) cause the remaining capacity of the secondary battery (41) to be displayed in a color at a gradation level between the first color and the second color when the slope of the SOC-OCV curve is greater than or equal to the low reliability level threshold value, but less than the high reliability level threshold value.

With this, by narrowing the range of the OCV to be shown at gradation levels, it is possible to prevent a change in the color of indication with respect to a small change in the OCV from becoming subtle.

[Item 5]

The remaining capacity notification device (30) according to item 2 or 3, wherein the notification control unit (313, 314) performs control to (i) cause the remaining capacity of the secondary battery (41) to be displayed in a first color when the slope of the SOC-OCV curve that corresponds to the SOC indicating the remaining capacity that the user is to be notified of is less than a threshold value, and (ii) cause the remaining capacity of the secondary battery (41) to be displayed in a second color when the slope of the SOC-OCV curve is greater than or equal to the threshold value.

With this, the user can be notified of the reliability level of the SOC through a simple indication.

[Item 6]

The remaining capacity notification device (30) according to any one of items 1 to 5, wherein after charging or discharging of the device (3) stops, the SOC indicating the remaining capacity that the user is to be notified of is calculated by calculating a weighted average of a SOC calculated by a current integration method and a SOC calculated by an OCV method, and as time elapses after the charging or the discharging of the device (3) stops, a contribution of the SOC calculated by the OCV method increases.

With this, by allowing the user to recognize a change in the reliability level of the SOC after the charging or the discharging stops, the user can be aware of the need to reset the parameters.

[Item 7]

A remaining capacity notification method for notifying a user of a device (3) of a remaining capacity of a secondary battery (41) mounted in the device (3), the remaining capacity notification method including:

determining a reliability level of a SOC on the basis of a slope of a SOC-OCV curve of the secondary battery (41), the SOC representing a state of charge and indicating the remaining capacity of the secondary battery (41) that the user is to be notified of, the slope corresponding to the SOC, the OCV representing an open circuit voltage; and performing control to cause the user to be notified of the remaining capacity of the secondary battery (41) in a form of notification based on the reliability level of the SOC that has been determined.

This allows the user to naturally learn how to find and reset a SOC error in normal operation.

[Item 8]

A remaining capacity notification program for notifying a user of a device (3) of a remaining capacity of a secondary battery (41) mounted in the device (3), the remaining capacity notification program causing a computer to execute:

a process of determining a reliability level of a SOC on the basis of a slope of a SOC-OCV curve of the secondary battery (41), the SOC representing a state of charge and indicating the remaining capacity of the secondary battery (41) that the user is to be notified of, the slope corresponding to the SOC, the OCV representing an open circuit voltage; and a process of performing control to cause the user to be notified of the remaining capacity of the secondary battery (41) in a form of notification based on the reliability level of the SOC that has been determined.

This allows the user to naturally learn how to find and reset a SOC error in normal operation.

Reference Signs List

| | |
|---|---|
| 1 | operation management support system |
| 2 | operation management terminal device |
| 3 | electric motor vehicle |
| 4 | charger |
| 5 | network |
| 6 | commercially available electric power system |
| 11 | processing unit |
| 111 | travel data obtainment unit |
| 112 | corrected SOC calculation unit |
| 113 | charging/discharging recommendation determination unit |
| 114 | battery management information generation unit |
| 12 | storage unit |

| 121 | travel data storage unit |
|---|---|
| 122 | battery management information storage unit |
| 13 | communication unit |
| 30 | vehicle control unit |
| 310 | processing unit |
| 311 | SOC obtainment unit |
| 312 | reliability level determination unit |
| 313 | display control unit |
| 314 | speech synthesis unit |
| 320 | storage unit |
| 321 | travel data storage unit |
| 31f | front wheel |
| 31r | rear wheel |
| 32f | front wheel shaft |
| 32r | rear wheel shaft |
| 33 | transmission |
| 34 | motor |
| 35 | inverter |
| 361 | GPS sensor |
| 362 | vehicle speed sensor |
| 37 | wireless communication unit |
| 37a | antenna |
| 38 | display unit |
| 39 | loudspeaker |
| 40 | power system |
| 41 | battery pack |
| 42 | battery management unit |
| 43 | voltage measurement unit |
| 44 | temperature measurement unit |
| 45 | current measurement unit |
| 46 | battery control unit |
| E1-En | cell |
| RY1-RY2 | relay |
| T1-T2 | temperature sensor |
| Rs | shunt resistor |

**Claims**

1.  A remaining capacity notification device for notifying a user of a device of a remaining capacity of a secondary battery mounted in the device, the remaining capacity notification device comprising:

    a reliability level determination unit that determines a reliability level of a state of charge (SOC) on the basis of a slope of a SOC-open circuit voltage (OCV) curve of the secondary battery, the SOC indicating the remaining capacity of the secondary battery that the user is to be notified of, the slope corresponding to the SOC; and
    a notification controller that performs control to cause the user to be notified of the remaining capacity of the secondary battery in a form of notification based on the reliability level of the SOC that has been determined.

2.  The remaining capacity notification device according to claim 1, wherein
    the reliability level determination unit evaluates the reliability level of the SOC indicating the remaining capacity that the user is to be notified of, as being higher, as the slope of the SOC-OCV curve that corresponds to the SOC indicating the remaining capacity that the user is to be notified of increases.

3.  The remaining capacity notification device according to claim 2, wherein
    the notification controller performs control to cause the remaining capacity of the secondary battery to be displayed or audibly output more conspicuously as the reliability level of the SOC that has been determined increases.

4.  The remaining capacity notification device according to claim 2 or 3, wherein

the notification controller performs control to (i) cause the remaining capacity of the secondary battery to be displayed in a first color when the slope of the SOC-OCV curve that corresponds to the SOC indicating the remaining capacity that the user is to be notified of is less than a low reliability level threshold value, (ii) cause the remaining capacity of the secondary battery to be displayed in a second color when the slope of the SOC-OCV curve is greater than or equal to a high reliability level threshold value, and (iii) cause the remaining capacity of the secondary battery to be displayed in a color at a gradation level between the first color and the second color when the slope of the SOC-OCV curve is greater than or equal to the low reliability level threshold value, but less than the high reliability level threshold value.

5. The remaining capacity notification device according to claim 2 or 3, wherein
the notification controller performs control to (i) cause the remaining capacity of the secondary battery to be displayed in a first color when the slope of the SOC-OCV curve that corresponds to the SOC indicating the remaining capacity that the user is to be notified of is less than a threshold value, and (ii) cause the remaining capacity of the secondary battery to be displayed in a second color when the slope of the SOC-OCV curve is greater than or equal to the threshold value.

6. The remaining capacity notification device according to any one of claims 1 to 5, wherein
after charging or discharging of the device stops, the SOC indicating the remaining capacity that the user is to be notified of is calculated by calculating a weighted average of a SOC calculated by a current integration method and a SOC calculated by an OCV method, and as time elapses after the charging or the discharging of the device stops, a contribution of the SOC calculated by the OCV method increases.

7. A remaining capacity notification method for notifying a user of a device of a remaining capacity of a secondary battery mounted in the device, the remaining capacity notification method comprising:

determining a reliability level of a SOC on the basis of a slope of a SOC-OCV curve of the secondary battery, the SOC representing a state of charge and indicating the remaining capacity of the secondary battery that the user is to be notified of, the slope corresponding to the SOC, the OCV representing an open circuit voltage; and performing control to cause the user to be notified of the remaining capacity of the secondary battery in a form of notification based on the reliability level of the SOC that has been determined.

8. A remaining capacity notification program for notifying a user of a device of a remaining capacity of a secondary battery mounted in the device, the remaining capacity notification program causing a computer to execute:

a process of determining a reliability level of a SOC on the basis of a slope of a SOC-OCV curve of the secondary battery, the SOC representing a state of charge and indicating the remaining capacity of the secondary battery that the user is to be notified of, the slope corresponding to the SOC, the OCV representing an open circuit voltage; and
a process of performing control to cause the user to be notified of the remaining capacity of the secondary battery in a form of notification based on the reliability level of the SOC that has been determined.

# FIG. 1

Electric motor vehicle 3

Electric motor vehicle 3

Electric motor vehicle 3

Charger 4

Operation management terminal device 2

Operation management support system 1

5

# FIG. 2

EP 4 316 894 A1

# FIG. 3

# FIG. 4

30

310

311

312

SOC obtainment
unit

Reliability level
determination unit

313

314

Display control
unit

Speech synthesis
unit

Processing unit

37

46

38

39

320

321

Travel data
storage unit

Storage unit

Vehicle control unit

# FIG. 5

# FIG. 6A

Reliability level of SOC

Remaining battery capacity reliability level[mV/%]

# FIG. 6B

Reliability level of downtime

Downtime[h]

38

FIG. 7A

Reliability level (low)

38

FIG. 7B

Reliability level (moderate)

38

FIG. 7C

Reliability level (high)

# FIG. 8

Color of remaining
battery capacity
indication

Downtime

0 hours                                                                   3 hours

# FIG. 9

5

1

13

Communication
unit

11

111

112

Travel data
obtainment unit

Corrected SOC
calculation unit

113

114

Charging/discharging
recommendation
determination unit

Battery management
information creation
unit

Processing unit

12

121

122

Travel data
storage unit

Battery management
information storage unit

Storage unit

Operation management support system

# FIG. 10

Lower limit SOC    Upper limit SOC

# FIG. 11

| Vehicle ID | XXXX |
|---|---|
| Message | Discharging recommendation |
| Presented SOC | 50 |
| Corrected SOC | 40 |
| Reliability level of presented SOC | 0.01 |
| Reliability level of downtime | 0 |

# FIG. 12

Low SOC region    Normal region    Normal region
High reliability region  High reliability region  High reliability region

**FIG. 13A**

| Normal region |
|---|

Discharging recommendation

Error xx%

**FIG. 13B**

| High reliability level region |
|---|

Discharging recommendation

Error yy%

**FIG. 13C**

| Low SOC region |
|---|

Charging recommendation

Error zz%

# FIG. 14

Start

S10 — Lower limit SOC = SOCv – voltage margin

S11 — Downtime > set time? **N** / **Y**

S12 — SOC error = presented SOC – lower limit SOC

S13 — Corrected SOC = presented SOC – SOC error

S14 — Corrected SOC > low SOC threshold value? **N** / **Y**

S15 — Discharging recommendation

S16 — Charging recommendation

S17 — Remaining capacity monitoring ended? **N** / **Y**

End

FIG. 15A

38

Fully charged

FIG. 15B

38

SOC60%

## INTERNATIONAL SEARCH REPORT

| International application No. |
| --- |
| **PCT/JP2022/005380** |

**A. CLASSIFICATION OF SUBJECT MATTER**

*B60L 3/00*(2019.01)i; *H02J 7/00*(2006.01)i; *B60L 58/12*(2019.01)i; *G01R 31/382*(2019.01)i; *G01R 31/3828*(2019.01)i; *G01R 31/3835*(2019.01)i; *G01R 31/385*(2019.01)i; *G01R 31/387*(2019.01)i; *H01M 10/48*(2006.01)i
FI:  G01R31/387; H02J7/00 X; H02J7/00 P; H01M10/48 P; G01R31/3828; G01R31/3835; B60L58/12; B60L3/00 S; G01R31/382; G01R31/385

According to International Patent Classification (IPC) or to both national classification and IPC

**B. FIELDS SEARCHED**

Minimum documentation searched (classification system followed by classification symbols)

H01M10/48; B60L3/00; H02J7/00; B60L58/12; G01R31/382; G01R31/3828; G01R31/3835; G01R31/385; G01R31/387

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | WO 2020/170964 A1 (GS YUASA INT LTD) 27 August 2020 (2020-08-27)<br>    paragraphs [0070]-[0080], fig. 10 | 1-3, 6-8 |
| A | | 4-5 |
| Y | JP 2018-63115 A (TOYOTA MOTOR CORP) 19 April 2018 (2018-04-19)<br>    paragraphs [0018], fig. 2 | 1-3, 6-8 |
| Y | WO 2018/012364 A1 (MURATA MANUFACTURING CO., LTD.) 18 January 2018<br>(2018-01-18)<br>    paragraphs [0002]-[0003] | 1-3, 6-8 |
| Y | JP 2020-61824 A (HONDA MOTOR CO LTD) 16 April 2020 (2020-04-16)<br>    paragraphs [0072]-[0075], [0081], fig. 7 | 1-3, 6-8 |
| Y | WO 2014/020643 A1 (SANYO ELECTRIC CO., LTD.) 06 February 2014 (2014-02-06)<br>    paragraphs [0075]-[0079] | 1-3, 6-8 |

☑ Further documents are listed in the continuation of Box C.   ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| **18 March 2022** | **05 April 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

International application No.

**PCT/JP2022/005380**

### C. DOCUMENTS CONSIDERED TO BE RELEVANT

| Category* | Citation of document, with indication, where appropriate, of the relevant passages | Relevant to claim No. |
|---|---|---|
| Y | JP 2004-239748 A (SONY ERICSSON MOBILECOMMUNICATIONS JAPAN INC) 26 August 2004 (2004-08-26) paragraph [0057] | 3 |
| Y | JP 2014-25739 A (SANYO ELECTRIC CO., LTD.) 06 February 2014 (2014-02-06) paragrpahs [0069]-[0073], fig. 17 | 6 |
| A | JP 2010-136553 A (TOYOTA MOTOR CORP) 17 June 2010 (2010-06-17) entire text, all drawings | 1-8 |
| A | JP 2010-283922 A (TOYOTA MOTOR CORP) 16 December 2010 (2010-12-16) entire text, all drawings | 1-8 |
| A | JP 2020-64030 A (TOYOTA MOTOR CORP) 23 April 2020 (2020-04-23) entire text, all drawings | 1-8 |
| A | JP 2009-208484 A (CALSONIC KANSEI CORP) 17 September 2009 (2009-09-17) paragraphs [0029]-[0030], fig. 4 | 4-5 |
| A | US 2001/0006906 A1 (NOKIA MOBILE PHONES LIMITED) 05 July 2001 (2001-07-05) entire text, all drawings | 1-8 |

Form PCT/ISA/210 (second sheet) (January 2015)

### INTERNATIONAL SEARCH REPORT
**Information on patent family members**

| International application No. |
| --- |
| **PCT/JP2022/005380** |

| Patent document cited in search report | | | Publication date (day/month/year) | Patent family member(s) | | | Publication date (day/month/year) |
| --- | --- | --- | --- | --- | --- | --- | --- |
| WO | 2020/170964 | A1 | 27 August 2020 | (Family: none) | | | |
| JP | 2018-63115 | A | 19 April 2018 | (Family: none) | | | |
| WO | 2018/012364 | A1 | 18 January 2018 | US paragraphs [0003]-[0004] CN | 2019/0079138 109463022 | A1 A | |
| JP | 2020-61824 | A | 16 April 2020 | US paragraphs [0083]-[0086], [0092], fig. 7 CN | 2020/0108730 111002828 | A1 A | |
| WO | 2014/020643 | A1 | 06 February 2014 | EP paragraphs [0075]-[0079] | 2881749 | A1 | |
| JP | 2004-239748 | A | 26 August 2004 | (Family: none) | | | |
| JP | 2014-25739 | A | 06 February 2014 | (Family: none) | | | |
| JP | 2010-136553 | A | 17 June 2010 | (Family: none) | | | |
| JP | 2010-283922 | A | 16 December 2010 | US entire text, all drawings WO CN | 2012/0065824 2010/140044 102803977 | A1 A1 A | |
| JP | 2020-64030 | A | 23 April 2020 | US entire text, all drawings EP CN | 2020/0125311 3640084 111071104 | A1 A1 A | |
| JP | 2009-208484 | A | 17 September 2009 | (Family: none) | | | |
| US | 2001/0006906 | A1 | 05 July 2001 | EP entire text, all drawings GB | 1111400 2357585 | A1 A | |

Form PCT/ISA/210 (patent family annex) (January 2015)

**EP 4 316 894 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015038437 A
- JP 2017083474 A